# Europäisches Patentamt
# European Patent Office
# Office européen des brevets

(11) Publication number: **0 137 045**
**B1**

(12) **EUROPEAN PATENT SPECIFICATION**

(45) Date of publication of patent specification: **18.05.88**

(21) Application number: **84900751.3**

(22) Date of filing: **10.02.84**

(86) International application number:
**PCT/JP84/00040**

(87) International publication number:
**WO 84/03194 16.08.84 Gazette 84/20**

(51) Int. Cl.⁴: **H 05 K 13/00, B 65 D 73/02**

(54) **TAPED SEMICONDUCTOR ELEMENTS.**

(30) Priority: **10.02.83 JP 21183/83**

(43) Date of publication of application:
**17.04.85 Bulletin 85/16**

(45) Publication of the grant of the patent:
**18.05.88 Bulletin 88/20**

(84) Designated Contracting States:
**DE FR GB NL**

(56) References cited:
**US-A-4 344 219**

**No relevant documents have been disclosed**

The file contains technical information
submitted after the application was filed and
not included in this specification

(73) Proprietor: **SONY CORPORATION**
**7-35 Kitashinagawa 6-Chome Shinagawa-ku**
**Tokyo 141 (JP)**

(72) Inventor: **MATSUMOTO, Shigeo**
**Sony Corporation 7-35, Kitashinagawa 6-chome**
**Shinagawa-ku Tokyo 141 (JP)**
Inventor: **IGARASHI, Tsutomu**
**Sony Corporation 7-35, Kitashinagawa 6-chome**
**Shinagawa-ku Tokyo 141 (JP)**

(74) Representative: **Cotter, Ivan John et al**
**D. YOUNG & CO. 10 Staple Inn**
**London WC1V 7RD (GB)**

Courier Press, Leamington Spa, England.

## Description

This invention relates to taped bodies of semiconductor variable capacitors in which the capacitors are sequentially taped.

In very high frequency (VHF) and ultra high frequency (UHF) tuners of, for example, a television receiver, a plurality of variable capacitors are used in one tuner. In this case, it is desired that the capacitance-voltage (C-V) characteristics of the variable capacitors used in the same tuner be made as uniform as possible, and that the characteristics of the capacitors used in the same tuner should lie within a predetermined deviation value. Accordingly, the C-V characteristics of the variable capacitors are measured and the capacitors are sorted into sets of N, where N is the number of the capacitors needed for one tuner and is for example, equal to 4 to 8, such that the characteristics of the N (for example 4) capacitors of each set lie within a predetermined deviation value. That is, the variable capacitors are so grouped that the C-V characteristics of each set of N (for example 4) thereof lie within the predetermined deviation value, and every such set is assembled into one circuit or instrument, for example a tuner.

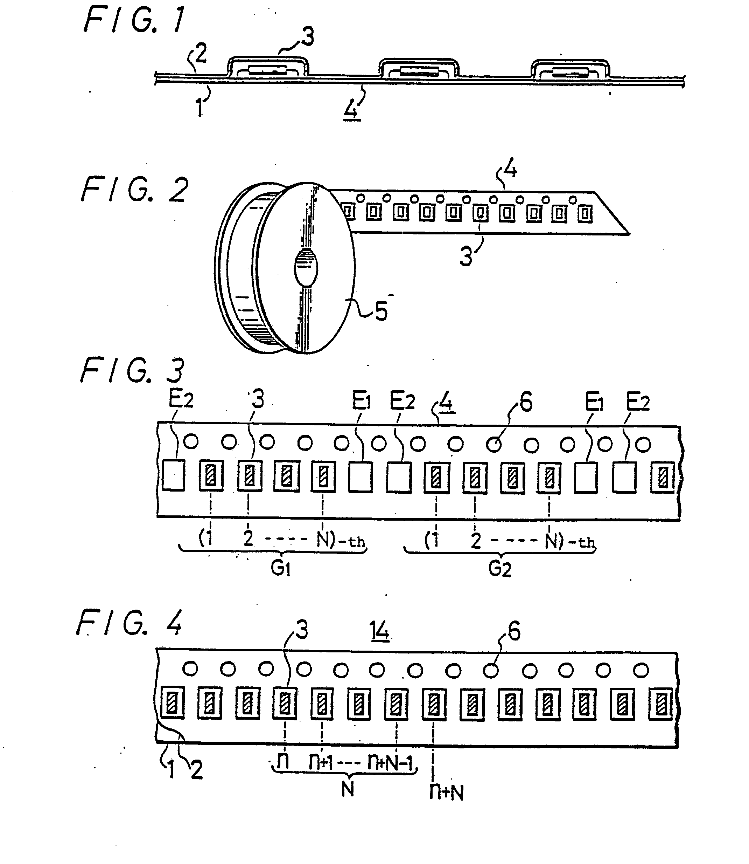

If small assembly parts such as variable capacitors of this kind are individually handled, the handling thereof become complicated and the handling can give rise to defective products. To avoid these defects, and to facilitate the carrying out of an automatic process in which each group of parts as mentioned above is assembled into one circuit or instrument of various kinds, it has been proposed to employ, as shown by way of a schematic cross-sectional view in Figure 1 of the accompanying drawings, a taped body in which a plurality of semiconductor parts 3, for example variable capacitors, are aligned and packed with a predetermined spacing, that is they are taped.

The taped body can be of a construction as, for example, shown in Figure 1, in which semiconductor parts 3 (for example variable capacitors) are gripped between flexible resin tapes 1 and 2, and the portions of the tapes 1 and 2 surrounding the parts 3 are pressed against each other, whereby the parts 3, which are aligned with a predetermined spacing between them in the longitudinal direction of the tapes 1 and 2, are packaged. Such a taped body 4 may, for example, have 2400 parts aligned in it, and the body 4 is wound around a reel 5 as shown in Figure 2 of the accompanying drawings. Upon assembling circuits or instruments, the taped body 4 is supplied from the reel 5. The semiconductor parts 3 aligned on the taped body 4 are sequentially removed from their packaged places in the order of their alignment and then mounted at predetermined positions, thereby to assemble various circuits or instruments.

In the taped body 4, the parts 3 making up each set of N capacitors having the characteristics which lie within the predetermined characteristic deviation value, and destined to be used in one circuit or instrument, are aligned as a group or set. That is, the sets of N parts 3 are separately aligned to form groups or sets $G_1$, $G_2$ ... as shown in Figure 3 of the accompanying drawings. Between adjacent groups $G_1$ and $G_2$ ... there are provided portions $E_1$, $E_2$ in which the parts 3, for example, are not packaged, or marks or the like are provided, whereby an indication is provided at each group of parts. The taped body 4 is provided with feeding perforations (such as that shown at 6 in Figure 3) for a sprocket which is used to move the taped body 4 in its longitudinal direction. When the parts 3 packaged in the taped body 4 are mounted, each group $G_1$, $G_2$ ... thereof is assembled into one circuit or instrument.

In a taped body made as just described, the characteristics of the respective assembly parts are selected to lie within the predetermined deviation value only within each group. No consideration is given to the relationship of the characteristics of the parts in adjacent groups, for example a part disposed at the end of one group and a part disposed at the beginning of an adjoining group. As a result, the characteristics thereof do not always lie within the predetermined deviation value. Therefore, when a taped body of semiconductor parts of this kind is used to assemble and produce the circuits or instruments, if any one part within one group of N parts becomes defective due to mis-mounting or the like, the other (N-1) parts in this group have to be abandoned and the N parts of another group have to be used.

According to the invention there is provided a taped body of semiconductor variable capacitors in which the capacitors are sequentially taped, wherein the sequence in which the capacitors are positioned along the taped body is selected in accordance with the values of a characteristic of the capacitors such that the values of the characteristic of every set of N successive ones of the capacitors are such as to lie within a predetermined deviation value.

The invention also provides a first and a second taped body each as just defined, in which the values of the characteristic of N of the semiconductor variable capacitors from an $n^{th}$ one at the end of the first taped body to an $(n+N-1)^{th}$ one at the beginning of the second taped body are such as to lie within said predetermined deviation value and the values of the characteristic of the N capacitors from the $(n+1)^{th}$ one of the first taped body to the $(n+N)^{th}$ one of the second taped body also are such as to lie within said predetermined deviation value.

The invention will now be further described, by way of illustrative and non-limiting example, with reference to the accompanying drawings, in which:

Figure 1 is a schematic cross-sectional view of a taped body of semiconductor parts;

Figure 2 is a perspective view illustrating the taped body wound around a reel;

Figure 3 is a plan view illustrating part of a previously proposed taped body of semiconductor parts; and

Figure 4 is a plan view of part of a taped body of semiconductor parts embodying the present invention.

Figure 4 shows a taped body 14 of semiconductor parts embodying the invention in which, similarly to Figure 1, the semiconductor parts 3, which are semiconductor variable capacitors, are aligned between the two flexible resin tapes 1 and 2 with a predetermined spacing along the longutidinal direction of the tapes 1 and 2. The tapes 1 and 2 are then laminated by, for example, hot pressing at portions thereof surrounding the parts 3 to thereby carry out alignment packaging, namely the taping.

When a circuit or instrument to be assembled is, for example, a tuner of a television receiver, the number N of the semiconductor variable capacitors 3 used in one tuner ranges from 4 to 8 and the characteristic of each of the variable capacitors used in the same tuner as to lie within a capacity deviation value ranging from, for example, 2.5 to 3.5%.

In the case of the taped body 14, the characteristics of N adjacent ones of the variable capacitors lie within the above capacity deviation value of 2.5 to 3.0%. The variable capacitors are selected such that when N adjacent variable capacitors 3 are taken out from any of the places in the alignment, the characteristic of each of the N variable capacitors lies within the capacity deviation value ranging from 2.5 to 3.0%. For example, consider the semiconductor variable capacitors 3 which are serially arrayed in the direction towards the right in Figure 4. If N semiconductor capacitors 3 are considered as one unit, the N successive capacitors from an $n^{th}$ one to an $(n+N-1)^{th}$ one are selected from capacitors having characteristics which lie within the predetermined characteristic deviation value. Further, the N successive capacitors from the $(n+1)^{th}$ one to the $(n+N)^{th}$ have characteristics which lie within the predetermined deviation value. That is, the capacitors 3 are selected and then aligned such that any (every) N adjacent ones of the capacitors 3 have characteristics which lie within the predetermined deviation value.

The taped body 14, which has a predetermined length, is wound around a reel as mentioned above. When it is intended to manufacture a large number of circuits or instruments in which the capacitors 3 are used, whereby a plurality of the reels are used in sequence, N successive ones of the capacitors comprising capacitors at the end of one reel and capacitors at the beginning of the following reel are similarly selected so that their characteristics lie within the predetermined deviation value.

In the case of the taped body 14, the capacitors 3 are not grouped in sets or groups of N which are used as units. Instead, the capacitors 3 are serially aligned and then taped.

When the characteristics of the capacitors 3 which are to be aligned and packaged with such an alignment relation are measured beforehand it is found, in practice, regarding semiconductor elements cut out from the same wafer, that semiconductor elements adjacent to one another on the wafer tend to have characteristics which are approximated to one another. Therefore, if the array relationship among the respective semiconductor elements on the wafer is considered and those elements which are adjacent to each other are sequentially taken out, it is possible to select elements having characteristics which are approximated to one another. Accordingly, it is relatively easy to take out and array elements whose characteristics lie within the above deviation value.

The measurement of the C-V characteristics of the variable capacitors 3 is carried out after a large number of elements formed on a semiconductor wafer are separated by pelletising the wafer, and each separated element is bonded on, for example, a header or casing having two terminals and subjected to resin moulding as required so as to provide the capacitors 3. The C-V characteristic is determined by measuring the capacitance values C of each element when supplied with predetermined voltages of, for example, 2V, 7V, 12V, 14V, 20V, 25V and so on. Elements having measured values lying within the above predetermined deviation value are selected and taped.

When the taped body 14 is used in assembling various circuits, instruments and so on, if N capacitors 3 which are adjacent to each other are sequentially used as each unit, it is possible to assemble various circuits or instruments which have predetermined characteristics. If, for example, the N parts from an $n^{th}$ one to an $(n+N-1)^{th}$ one are assembled into a circuit or instrument, and if the $n^{th}$ one, for example, becomes defective due to mis-mounting or the like, it is not necessary (as in the case of the taped body 4 of Figure 3) to exclude or discard the (N-1) successive capacitors from the $(n+1)^{th}$ one to the $(n+N-1)^{th}$ one: instead, the N capacitors starting from the $(n+1)^{th}$ one, namely, up to the $(n+N)^{th}$ one, can be assembled into the circuit or instrument. That is, it is possible to save the (N-1) successive capacitors from the $(n+1)^{th}$ one to the $(n+N-1)^{th}$ one. Therefore, it is possible to reduce the number of capacitors 3 which cannot be used, but must be left in the taped body, with the result that efficient assembly and decrease of manufacturing costs can be expected.

**Claims**

1. A taped body (14) of semiconductor variable capacitors (3) in which the capacitors are sequentially taped, wherein the sequence in which the capacitors are positioned along the taped body is selected in accordance with the values of a characteristic of the capacitors such that the values of the characteristics of every set of N successive ones of the capacitors are such as to lie within a predetermined deviation value.

2. A first and a second taped body each according to claim 1, in which the values of the characteristic of N of the semiconductor variable capacitors from an $n^{th}$ one at the end of the first taped body to an $(n+N-1)^{th}$ one at the beginning of the second taped body are such as to lie within said predetermined deviation value and the values of the characteristic of the N capacitors from the $(n+1)^{th}$ one of the first taped body to the $(n+N)^{th}$ one of the second taped body also are such as to lie within said predetermined deviation value.

## Patentansprüche

1. Körper (14) in Bandform mit veränderbaren Halbleiter-Kondensatoren (3), wobei die Aufeinanderfolge, in welcher die Kondensatoren längs des Körpers in Bandform positioniert sind, in Übereinstimmung mit den Kennwerten der Kondensatoren derart ausgewählt ist, daß die Kennwerte jedes Satzes von N aufeinanderfolgenden der Kondensatoren derart sind, daß sie innerhalb eines vorbestimmten Abweichungswertbereichs liegen.

2. Erster und zweiter Körper in Bandform nach Anspruch 1, wobei die Kennwerte von N der veränderbaren Halbleiter-Kondensatoren von einem n-ten derselben an dem Ende des ersten Körpers in Bandform bis zu einem (n+N-1)-ten derselben an dem Angang des zweiten Körpers in Bandform derart sind, daß sie innerhalb des vorbestimmten Abweichungswertbereichs liegen und die Kennwerte der N Kondensatoren von dem (n+1)-ten derselben des ersten Körpers bis zu dem (n+N)-ten derselben des zweiten Körpers derart sind, daß sie innerhalb des vorbestimmten Abweichungswertbereichs liegen.

## Revendications

1. Corps en bande (14) de condensateurs variables semi-conducteurs (3) dans lequel les condensateurs sont séquentiellement mis en bande, où la séquence suivant laquelle les condensateurs sont placés le long du corps en bande est choisie en fonction des valeurs d'une caractéristique des condensateurs de façon que les valeurs de la caractéristique de tout groupe de N éléments successifs pris parmi les condensateurs soient telles qu'elles se trouvent dans les limites d'une valeur d'écart prédéterminée.

2. Premier et deuxième corps en bande, chacun selon la revendication 1, dans lesquels les valeurs de la caractéristique de N des condensateurs variables semiconducteurs allant d'un $n^{ème}$ se trouvant à la fin du premier corps en bande à un $(n+N-1)^{ème}$ se trouvant au début du deuxième corps en bande sont telles qu'elles se trouvent dans les limites de ladite valeur d'écart prédéterminée, et les valeurs des caractéristiques des N condensateurs allant du $(n+1)^{ème}$ du premier corps en bande au $(n+N)^{ème}$ du deuxième corps en bande sont également telles qu'elles se trouvent dans les limites de ladite valeur d'écart prédéterminée.

0 137 045

FIG. 1

FIG. 2

FIG. 3

FIG. 4